# EUROPEAN PATENT SPECIFICATION

(11) **EP 0 594 895 B1**
(45) Date of publication and mention of the grant of the patent: **08.07.1998**
(21) Application number: 92203312.1
(22) Date of filing: 28.10.1992
(51) Int. Cl.: G03D 15/02, G03D 3/13

(54) **Photographic processing apparatus**
Photographisches Entwicklungsgerät
Appareil de traitement photographique

(43) Date of publication of application: 04.05.1994
(73) Proprietor: AGFA-GEVAERT N.V., 2640 Mortsel (BE)
(72) Inventor: Verlinden, Bart c/o Agfa-Gevaert N.V.,DIE 3800, B-2640 Mortsel (BE); Verhoest, Bart c/o Agfa-Gevaert N.V.,DIE 3800, B-2640 Mortsel (BE); van Humbeeck, Freddy c/o Afga-Gevaert N.V.,DIE3800, B-2640 Mortsel (BE); Domen, Albrecht c/o Agfa-Gevaert N.V., B-2640 Mortsel (BE)

(56) References cited:
- EP-A- 177 873
- EP-A- 417 740
- GB-A- 1 530 619

## Description

### Field of invention.

This invention relates to apparatus for the processing of photographic sheet materials and particularly for developing exposed photographic material, and more particularly to apparatus for developing lithographic offset printing plates.

### Background of invention.

In an apparatus or system for the development of aluminium lithographic printing plates of the type disclosed in EP 410500 it is advantageous to maintain the strength of the processing liquids within specified limits so as to maintain high quality printing plates, and reduce waste products.

During processing the photographic sheet material it is an advantage if the carry-over from one chemical bath to another chemical bath is kept to a minimum. It is therefore known to use pairs of squeeze rollers at the exit of a chemical bath to remove excess chemicals from the sheet material as it exits the bath.

A good removal of processing liquid is also required to reduce the drying time of the sheet material after the last process bath, and hence reduce energy use.

In order to obtain good imaging quality it is necessary for the rollers to exert a load in the order of 0.5 - 6.0 N/cm roller length to remove excess materials. To this end the rollers are biased together typically by springs which act on the ends of the roller shafts.

During the processing of the photographic material the roller can become coated with gelatin and if the apparatus is switched off with the rollers stationary and biased together then after several hours the rollers become glued together by the gelatin. As a result of this the roller surfaces may become damaged, and the drive gears may also be damaged when the apparatus is restarted.

Furthermore since the rollers have an elastomeric surface, if the apparatus is left with the squeeze rollers biased together, the rollers may take on a set and become temporarily deformed and when the apparatus is restarted this may result in poor quality image reproduction for the first few plates processed on the re-start, after which the deformation disappears.

It has been proposed to arrange a processor for aluminium printing plates in such a way that the rollers of the distinct roller pairs can be removed from each other during periods of non-use of the apparatus. One such like processor is disclosed in EP-A1 0 177.873.

### Object of invention.

The present invention aims to provide a processor of the type referred to, the mechanical construction of which is simpler.

### Statement of invention.

According to the present invention there is provided an apparatus for processing photographic sheet material as defined by claim 1.

The second cam means may comprise a circular cam fixed to said other roller shaft and the first cam means comprises an eccentric cam which is connected to said one roller shaft through a one way clutch so that in one direction of rotation of said one roller the eccentric cam is free to rotate relative to said one roller, and in the other direction of rotation the eccentric can is rotationally fast with said roller, so that rotation of the eccentric cam in said other direction of rotation causes the one roller to move away from the other roller.

### Brief Description of Drawings.

The invention will be described by way of example and with reference to the accompanying drawings in which :
Fig. 1 is a schematic layout of one embodiment of a processing apparatus according to the invention,
Fig.2 is an elevation showing one embodiment of the invention having a cam operable moving means showing the rollers in their open condition,
Fig. 3 is a side view of the rollers as shown in fig. 2 with the rollers in the rollers closed condition, and
Fig. 4 is a side view of the rollers of fig. 2 shown in the open condition.

### Detailed Description of the Invention

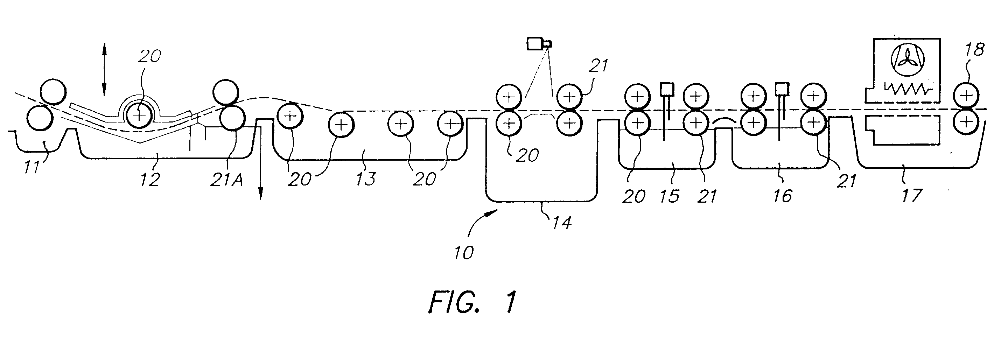

With reference to fig. 1 there is illustrated a longitudinal cross-section through an apparatus 10 for processing exposed photographic sheet material, in particular aluminium lithographic printing plates, of the type described in EP-A-410500.

EP-A-410500 discloses an imaging element containing an aluminium support provided with in the order given an image receiving layer and a silver halide emulsion. In the document there is disclosed a diffusion transfer reversal process (hereinafter called DTR-process) for obtaining a lithographic printing plate in which said imaging element is image-wise exposed and subsequently developed using a developing liquid or activating liquid in the presence of a silver halide complexing agent. The imaging element is then guided through a diffusion transfer zone so that the silver halide complexes formed during the development step are allowed to diffuse into the image-receiving layer where they are converted to silver. When the imaging element leaves the diffusion transfer zone a silver image is formed in the image receiving layer. The now useless photosensitive layer and optional other layers above the image receiving layer are then removed by rinsing the imaging element in a washing section. Finally the element now carrying a silver image on its surface is treated with a finishing liquid that contains so called hydrophobizing agent for improving the hydrophobicity of the silver image.

In the above described method for obtaining an aluminium based lithographic printing plate according to the DTR-process generally at least three different liquids are used i.e. a developing or activating liquid, a rinsing liquid and a finishing liquid.

The apparatus 10 is mounted within a generally rectangular housing which may include a rectangular metal frame (not shown) for supporting the various parts of the apparatus.

The apparatus comprises a sheet feed means 11, preferably a pair of rollers, a developing section 12, a diffusion transfer section 13, a wash section 14, a rinse section 15, a finishing section 16, a drier 17, and output rollers 18.

All these sections include conveyor rollers 20 and the exit ends of the developing section 12, wash section 14 and the finishing section 16 have sets of squeeze rollers 21 to remove excess liquid from the sheet material as it exits the respective section. Sets of squeeze roller 21 may also be used in the rinse sections.

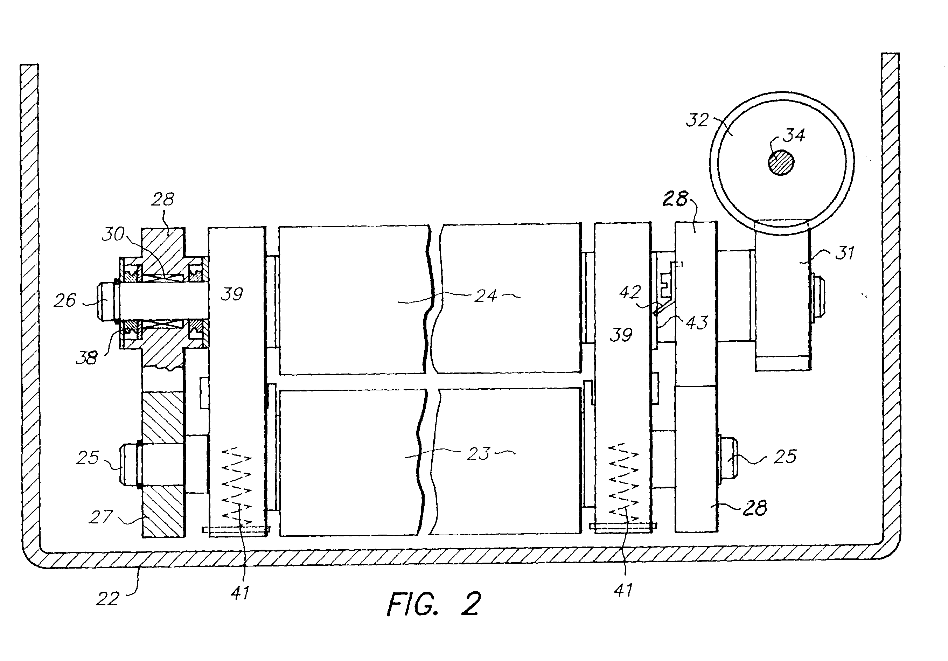

All the rollers, 11, 20, 21, 18 and squeeze rollers are linked by a single drive shaft 34 (see Fig. 2) to operate simultaneously to advance sheet material through the apparatus 10 from the feed means 11 to the output rollers 18.

The squeeze rollers 21 at the ends of the sections are best seen in Fig. 2 and since each set of squeeze rollers 21 is identical only one set of rollers will be described.

Each set of squeeze rollers 21 comprises a lower squeeze roller 23, and upper squeeze roller 24, which are fixed on respective shafts 25 and 26 for rotation.

The rotation shafts 25, 26 of the lower and upper rollers 23, 24 respectively have cams 27, 28 secured thereto at each end thereof. The cams 27 on the lower roller, shaft 25 are circular and may be fixed for rotation with the shaft 25. If the lower cams 27 are made from an engineering polymer such as nylon or acetal resin then the cams 27 may be rotatable on the shaft 25 when no load is applied to the cams and will be held fixed on the shaft by friction when a load is applied to the cams 27. The cams 28 on the upper roller shaft 26 are eccentric, and are secured on the shaft 26 through a one way clutch or bearing mechanism 30 which allows the cams 28 to rotate relative to the shaft 26 in one direction, but locks the cams relative to this shaft in the other direction of rotation (this is shown on one side of Fig. 2 only). The one way mechanism 30 is sealed on the shaft 26 to prevent contamination.

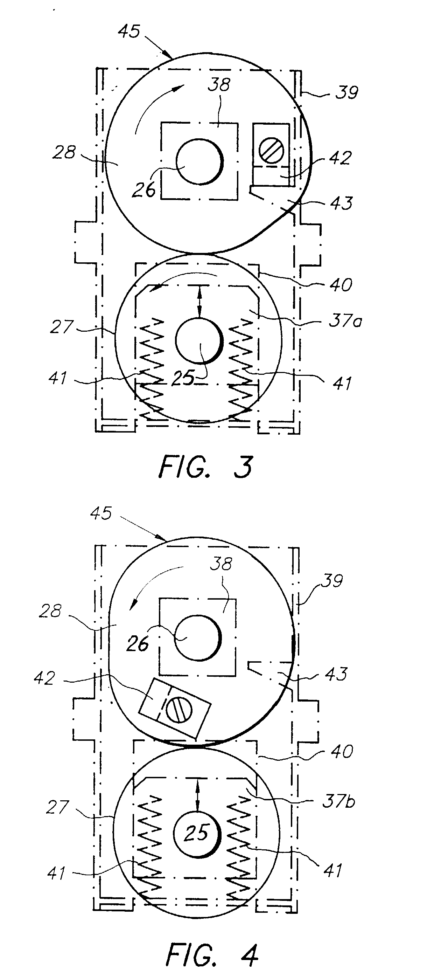

The upper roller 24 is a driven roller and the lower roller 23 is an idle roller. The two roller shafts 23, 24, rotate in bearings 37, 38 respectively which are held in a pair of frames 39 located one at each end of the rollers. The upper roller 24 rotates in bearing 38 fixed in the frames 39 and is rotated by a drive gear 31 which is driven by a worm screw 32. The lower roller 23 rotates in its bearings 37 and these bearings slide in guides 40 in the frames 39 so that the lower roller 23 is free to move towards and away from the upper roller 24 as the bearings 37 move between the positions 37a and 37b as shown in Figs. 3 and 4. Springs 41 bias the lower roller 23 towards the upper roller 24 by a force of up to 400 N. The lower roller 23 is free to move between 1 - 6 mm away from the upper roller in order to break the miniscus of any process liquid on the rollers.

The eccentric cams 28 on the upper roller 24 are each held in an "at-rest" position during said one direction of rotation by an index clip 42 which rests against an abutment 43 on the respective frame 39. This sets the starting position for the operation of the eccentric cams 28 when upper roller shaft 26 rotates in the other direction of rotation. For example the roller can be made to move apart over the first 180-210 degrees of rotation of the upper cam 28 relative to the lower cam 27, be held apart at a pre-set distance for 60 degrees of rotation, and then move together over the last 120 - 90 degrees of movement.

Thus in Fig. 3 with the upper roller 24 on shaft 26 rotating clockwise and the two rollers 23, 24 biased together by the springs 41, the lower roller 23 on shaft 25 is driven anticlockwise to pass sheet material through the rollers.

When the upper roller 24 is driven clockwise, the cam 28 rotates on its one way clutch 30 and is held stationary relative to the frame 39.

When the direction of rotation of the upper roller 24 is reversed, the cam 28 now turns with the upper roller and the eccentric cam 28 has its cam surface 45 working against the circular cam 27 to push the lower roller 23 against the bias of the springs 41 away from upper roller 24 (see figs. 2 and 4) and open the rollers. This breaks the meniscus of any fluid caught between the rollers.

The frames 39 are removeable from the housing of the apparatus so that the rollers 23, 24, frames 39 etc., can be removed from the housing as a complete squeeze roller set 21. The frames 39 are adapted to receive handles for the removal of the squeeze roller set, the frame 39 away from the worm drive 32 being lifted first to disengage the drive gear 31 from the worm drive 32.

Where a plurality of the above sets of rollers 21 are utilized in the apparatus 10 the eccentric cams 28 can be made to operate simultaneously or in step wise progression whichever is desired. In the preferred embodiment the eccentric cams 28 operate simultaneously.

## Claims

1. Apparatus (10) for processing photographic sheet material including at least two rollers (23) (24) rotatable on respective shafts (25) (26) and which are biased together, said apparatus comprising at each end of at least one roller shaft (26) a moving means operably connected with said one roller shaft (26) for relative movement of said one roller away from the other roller to open the roller, characterised in that said moving means comprises first cam means (28) at each end of said one roller shaft (26) that co-operate with second cam means (27) at each end of said other roller shaft (25) to cause the rollers (23, 24) to move apart.

2. Apparatus according to claim 1, wherein said second cam means comprises a circular cam (27) mounted on said other roller shaft (25) and the first cam means comprises an eccentric cam (28) which is connected to said one roller shaft (26) through a one way clutch (30) so that in one direction of rotation of said one roller the eccentric cam (28) is free to rotate relative to said one roller (24), and in the other direction of rotation the eccentric cam (28) is rotationally fast with said roller (24), so that rotation of the eccentric cam (28) in said other direction of rotation causes the two rollers (23, 24) to move away from each other.

3. Apparatus as claimed in claim 2, wherein the two roller shafts (25,26) are mounted at each end thereof in bearings (37, 38) held in a respective frame (39) so that said one roller (24) is an upper roller which is fixed in the frames and said other roller (23) is a lower roller which is slideably mounted in said frames, the lower roller (23) being biased towards the upper roller by spring means (41).

4. Apparatus according to claim 2 or 3 wherein the eccentric cams (28) have a cam lift of between 1 - 6 mm.

5. Apparatus as claimed in claim 4, wherein eccentric cams (28) are each held in an at-rest position relative to the frames (39) by an index clip (42) which seats against an abutment on the respective frame (39).

## Patentansprüche

1. Vorrichtung (10) zum Verarbeiten von photographischem Blattmaterial, mit mindestens zwei Walzen (23) (24), die sich auf jeweiligen Wellen (25) (26) drehen können und zusammen vorgespannt sind, wobei die Vorrichtung an jedem Ende mindestens einer Walzenwelle (26) ein bewegliches Mittel umfaßt, das zur Relativbewegung der einen Walze von der anderen Walze weg zum Öffnen der Walzen mit der einen Walzenwelle (26) arbeitend verbunden ist, dadurch gekennzeichnet, daß das bewegliche Mittel an jedem Ende der einen Walzenwelle (26) erste Nockenmittel (28) umfaßt, die mit zweiten Nockenmitteln (27) an jedem Ende der anderen Walzenwelle (25) zusammenwirken, um zu bewirken, daß sich die Walzen (23, 24) auseinanderbewegen.

2. Vorrichtung gemäß Anspruch 1, bei der das zweite Nockenmittel eine an der anderen Walzenwelle (25) befestigte kreisförmige Nocke (27) umfaßt und das erste Nockenmittel eine exzentrische Nocke (28) umfaßt, die über eine Einwegkupplung (30) mit der einen Walzenwelle (26) verbunden ist, so daß in der einen Drehrichtung der einen Walze die exzentrische Nocke (28) sich relativ zu der einen Walze (24) frei drehen kann und in der anderen Drehrichtung die exzentrische Nocke (28) mit der Walze (24) drehfest ist, so daß eine Drehung der exzentrischen Nocke (28) in der anderen Drehrichtung bewirkt, daß sich die beiden Walzen (23, 24) voneinander wegbewegen.

3. Vorrichtung nach Anspruch 2, bei der die beiden Walzenwellen (25, 26) an jedem Ende davon in Lagern (37, 38) befestigt sind, die im jeweiligen Rahmen (39) gehalten sind, so daß eine Walze (24) eine obere Walze ist, die in den Rahmen befestigt ist, und die andere Walze (23) eine untere Walze ist, die in den Rahmen gleitend befestigt ist, wobei die untere Walze (23) in Richtung der oberen Walze durch Federmittel (41) vorgespannt ist.

4. Vorrichtung nach Anspruch 2 oder 3, bei der die exzentrischen Nocken (28) einen Nockenhub von zwischen 1 - 6 mm aufweisen.

5. Vorrichtung nach Anspruch 4, bei der die exzentrischen Nocken (28) relativ zu den Rahmen (39) jeweils durch eine Indexklammer (42), die an einem Widerlager an dem jeweiligen Rahmen (39) anliegt, in einer Ruheposition gehalten werden.

## Revendications

1. Appareil (10) de traitement de matériau photographique en feuilles, comportant au moins deux rouleaux (23) (24) pouvant tourner sur des axes (25) (26) respectifs et poussés l'un contre l'autre, ledit appareil comprenant, à chaque extrémité d'au moins un axe (26) de rouleau, un moyen de déplacement connecté de manière fonctionnelle audit un axe (26) de rouleau en vue d'un mouvement relatif dudit un rouleau à l'écart de l'autre rouleau afin d'ouvrir les rouleaux, caractérisé en ce que ledit moyen de déplacement comprend un premier moyen à came (28), à chaque extrémité dudit un axe (26) de rouleau, coopérant avec un deuxième moyen à came (27), à chaque extrémité dudit autre axe (25) de rouleau, pour amener les rouleaux (23, 24) à s'écarter.

2. Appareil selon la revendication 1, dans lequel ledit deuxième moyen à came comprend une came circulaire (27) montée sur ledit autre axe (25) de rouleau, et le premier moyen à came comprend une came désaxée (28) connectée audit un axe (26) de rouleau par l'intermédiaire d'un embrayage unidirectionnel (30), de sorte que, dans un sens de rotation dudit un rouleau, la came désaxée (28) soit libre de tourner par rapport audit un rouleau (24), et que, dans l'autre sens de rotation, la came désaxée (28) soit solidaire en rotation dudit rouleau (24), de telle sorte que la rotation de la came désaxée (28) dans ledit autre sens de rotation amène les deux rouleaux (23, 24) à s'écarter l'un de l'autre.

3. Appareil selon la revendication 2, dans lequel les deux axes (25, 26) de rouleaux sont montés, à chacune de leur extrémité, dans des paliers (37, 38) retenus dans un support (39) respectif, de telle sorte que ledit un rouleau (24) constitue un rouleau supérieur fixé dans les supports, et ledit autre rouleau (23) constitue un rouleau inférieur monté à coulissement dans lesdits supports, le rouleau inférieur (23) étant poussé vers le rouleau supérieur par un moyen à ressort (41).

4. Appareil selon la revendication 2 ou 3, dans lequel les cames désaxées (28) présentent une levée de came comprise entre 1 et 6 mm.

5. Appareil selon la revendication 4, dans lequel les cames désaxées (28) sont chacune retenues dans une position de repos par rapport aux supports (39) au moyen d'une griffe d'arrêt (42) qui repose contre une butée sur le support (39) respectif.
